Europäisches Patentamt

European Patent Office

Office européen des brevets

(19)

(11) Publication number: **0 466 360 A1**

# EUROPEAN PATENT APPLICATION

(21) Application number: **91305783.2**

(22) Date of filing: **26.06.91**

(51) Int. Cl.⁵: **C04B 41/87**, C01B 31/04

(30) Priority: **12.07.90 GB 9015356**

(43) Date of publication of application:
**15.01.92 Bulletin 92/03**

(84) Designated Contracting States:
**DE FR GB IT NL SE**

(71) Applicant: **THE BRITISH PETROLEUM COMPANY P.L.C.**
**Britannic House, 1 Finsbury Circus**
**London EC2M 7BA(GB)**

(72) Inventor: **Griffin, Christopher James, The B.P.**

Company p.l.c.
**Chertsey Road, Sunbury-on-Thames**
**Middlesex, TW16 7LN(GB)**
Inventor: **Moss, Renny Neil, The B.P.**
Company p.l.c.
**Chertsey Road, Sunbury-on-Thames**
**Middlesex, TW16 7LN(GB)**

(74) Representative: **Scott, Susan Margaret et al**
**BP INTERNATIONAL LIMITED Patents & Agreements Division Chertsey Road**
**Sunbury-on-Thames Middlesex TW16 7LN(GB)**

(54) Process for coating ceramic filaments and novel coated ceramic filaments.

(57) A process for the deposition of a carbon coating on a filament which comprises passing the heated filament through a deposition chamber containing gases which, on contact with the hot filament, deposit a carbon coating; characterised in that the deposition chamber comprises distinct first and second regions, the first region having a greater diameter than the second region. The carbon coating comprises at least two distinct layers of carbon when viewed under a scanning electron microscope, one layer presenting a visual appearance of a laminated microstructure and a second layer presenting a homogeneous visual appearance.

FIG. 2

EP 0 466 360 A1

The present invention relates to a method for the preparation of a carbon coating on a ceramic filament and to novel carbon coated ceramic filaments.

A ceramic filament must be provided with a protective coating to eliminate strength reducing fibre-matrix chemical reactions if it is to be used successfully to reinforce metal matrix composites.

A well known technique for depositing carbon coatings on filaments utilises chemical vapour deposition (CVD). In a typical process, a filament is passed continuously through a deposition chamber containing gases which, on contact with a hot filament, deposit the desired coating. The filament is usually heated resistively by passage of an electric current.

Such a process provides a coated filament which retains its original strength. During the process however, it has been found that a layer of soot builds up within the deposition chamber, having the obvious consequence of reducing the efficiency of the process ie the tube blocks and the process has to be halted.

Furthermore, the resulting coated filament comprises a single layer of carbon. Such coatings are in general strong and do provide a protective coating around the filament. However, if cracking or shearing of the filament takes place, the cracks are found to propagate directly through the carbon layer.

We have now found that these problems can be overcome by using a deposition chamber which has two distinct regions, the two regions having a different diameter.

Accordingly, the present invention provides a process for the deposition of a carbon coating on a ceramic filament which comprises passing the heated filament through a deposition chamber containing gases which, on contact with the hot filament, deposit a carbon coating; characterised in that the deposition chamber comprises distinct first and second regions, the first region having a greater diameter than the second region.

The invention provides a process for the deposition of a carbon coating onto a filament wherein the process can be operated continuously since there is very little soot deposition on the reactor walls.

Furthermore, the combination of a thicker and thinner tube provides a process wherein the microstructure of the carbon layer can be influenced to give the desired properties. The resulting coated filament comprises two distinct layers of carbon. Additionally, composites prepared from these coated filaments exhibit a significant decrease in frictional shear stress between the filement and the matrix.

The carbon coating of the present invention is suitable for both silicon carbide filaments and/or boron filaments.

The deposition chamber is preferably a vertical tube comprising a first region and a second region which are in direct contact. Preferably, the two regions have a uniform cross-section. The first region may suitably be the upper region of the deposition chamber and may have an internal diameter of suitably 25-50 mm preferably 30-40 mm. The second region may suitably form the lower region of the chamber and may have an internal diameter of suitably 10-25 mm, preferably 15-25 mm. It is also equally possible that the thinner region may be the upper region and the thicker region may be the lower region. The thicker region may be suitably $\frac{1}{2}$ - 5 m long, preferably $1\frac{1}{2}$-$2\frac{1}{2}$ m long and the thinner region may suitably be $\frac{1}{4}$ - 5 m long, preferably $\frac{1}{2}$-$\frac{3}{4}$ m long.

The reaction tube may also of course comprise additional regions to the first and second. Such regions may be thinner and/or thicker than the first and second regions.

It has been found that especially good results have been obtained when the thicker first region forms the upper end of the chamber, the thinner second region forms the lower end of the chamber, the gas inlet is at the lower end of the chamber and the outlet is at the upper end.

The carbon coating layers are deposited on the filament using gases which decompose to produce a carbon layer. In general, a mixture of hydrocarbons and halogenated hydrocarbons can be used. Suitable decompositon temperatures are generally in the range of from 800-1300˚C, especially 900-1100˚C. In a preferred process for depositing a carbon coating, the gases comprise chloroform and a hydrocarbon having 1 to 6 carbon atoms. Any suitable C(1-6) hydrocarbon may be used, for example propane or preferably propene.

The volume ratio of chloroform to C(1-6) hydrocarbon may vary widely but is preferably in the range from 3:1 to 1:8, most preferably 1:1 to 1:4. If an inert carrier gas is used, the volume ratio of C(1-6) hydrocarbon to carrier gas is preferably in the range from 1:6 to 1:40, most preferably 1:15 to 1:25.

The gases in the deposition chamber may contain further components, for example an inert carrier gas such as argon or neon. Hydrogen may be present if desired or the reaction may be carried out in the absence of hydrogen.

In order to promote efficient deposition, the filament is preferably heated to a temperature in the range from 800 to 1300˚C most preferably 900 to 1100˚C. Most conveniently, the fibre is heated by a passage of an electric current supplied via two liquid metal electrodes through which the filament passes. These electrodes may contain pure mercury or liquid metal mixtures selected from mercury/indium, mercury/cadmium or gallium/indium. Most preferably, the electrodes contain a mercury/indium mixture.

A further advantage of the present invention is that the use of a deposition chamber which comprises two or more distinct regions provides a coating which has at least two distinct layers of carbon.

Accordingly, the present invention provides a ceramic filament having a carbon coating, the carbon coating when viewed under a scanning electron microscope comprising at least two distinct layers of carbon, a first layer presenting the visual appearance of a laminated microstructure and a second layer presenting a homogeneous visual appearance.

The microstructure of the carbon coating is surprisingly different to known prior art coated filaments, comprising two distinct layers which are readily recognisable under a scanning electron microscope. The first layer presents the appearance of having a laminated microstructure wherein the carbon grains are arranged parallel to the surface of the filament. The second layer is visually distinct from the laminated microstructure, presenting a homogeneous appearance.

The resulting two-layered coating has the advantage in that if cracking or shearing of the coated filament takes place, the cracks are less likely to propagate through the layers as experienced in prior art filaments. There is an increased tendency for the cracks to be deflected and propagation may occur through the laminar microstructure in a direction parallel to the surface. This effect provides the advantage that a composite prepared from coated filaments of the present invention exhibits low frictional shear stress between the filament and the matrix.

The two layers are distinct and are readily distinguishable when viewed under a scanning electron microscope. Further analysis of the coating has not provided additional information illustrating the marked difference between the two layers. It is therefore surprising that the bilayered coating results in a coated filament which is superior to known prior art.

The order of the layers is dependent upon the order of passage through the respective regions of the tube. Passage through the wide region will result in deposition of the layer presenting the visual appearance of a laminated microstructure while passage through the narrower region will provide the layer presenting a homogeneous appearance. Preferably, the filament passes through the wider region followed by the passage through the thinner region resulting in a coated ceramic filament having an inner layer of carbon having the visual appearance of a laminated microstructure and an outer layer having a homogeneous appearance.

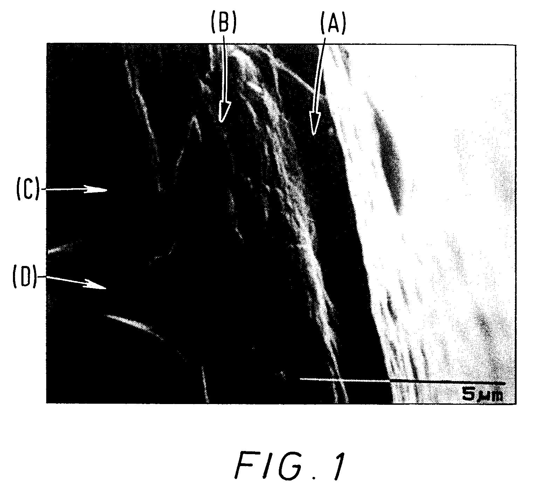

A cross-section through the carbon coating is shown in Figure 1. The cross-section was obtained using Scanning Electron Microscopy (SEM) at a magnification of 10,000X. It can be seen that the two layers are distinct and readily distinguishable. The upper layer (A) is the homogeneous layer, the lower layer (B) is the layer presenting the visual appearance of a laminated microstructure, on the silicon carbide fibre (C). The feature (D) is a fracture mark on the surface of the filament.

The process of the invention will now be illustrated with reference to the accompanying drawing and the following examples:

Example 1

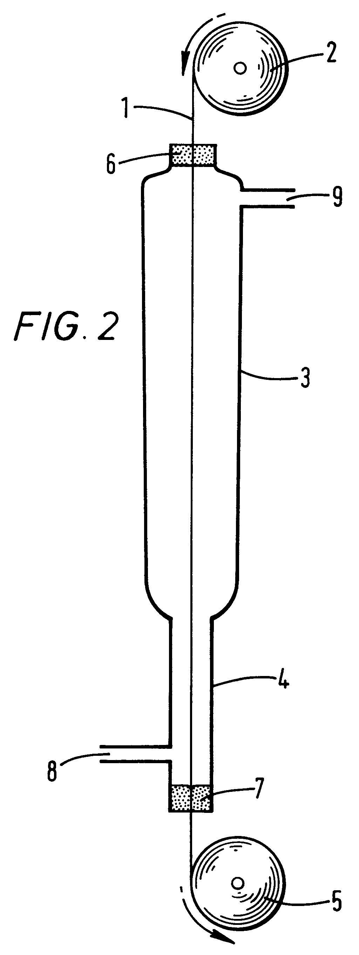

Figure 2 shows an apparatus which may be used to carry out the invention. A silicon carbide filament (1) is fed from a supply (2) via a tube comprising a wide upper tube (3) and a narrow lower tube (4), to a store (5). The filament (1) passes through liquid mercury/indium electrodes (6) and (7) at the extreme ends of the tube. The electrodes (6) and (7) form part of an electric heating circuit (not shown) providing current to the filament raising the filament to a temperature of from 900-1100°C. Argon (flow rate 1000 to 2000 standard cubic centimetres per minute (sccm)), propene (flow rate from 5 to 125 sccm) and chloroform (flow rate from 30 to 70 sccm) are fed into the tube at the lower end of region (4) via an inlet (8). Spent gases are removed at the upper end of region (3) via an outlet (9). The filament entering the store (5) has a high quality bimodal carbon coating.

Example 2. Preparation of Coated Filament

A carbon coated filament comprising two distinct layers of carbon according to the present invention was prepared using the apparatus of Example 1. The dimensions of the upper region was 1m in length and 32 mm in diameter. The lower region was 0.3 m in length and 22 mm in diameter.

Comparative Example. Preparation of Coated Filament

Carbon coated filaments comprising a single layer of carbon were prepared under similar conditions to Example 1 but using a deposition chamber which comprised a single region.

A coated filament was obtained using a deposition chamber of 1.5 m in length and 32 mm in diameter (Filament 2 of Table 1). A second coated filament was obtained from a chamber of 1.3 m in length and 22 mm in diameter. (Filament 3 of Table 1).

## Example 3. Measurement of Frictional Shear Stress

The coating performance of the three coated filaments was evaluated by measuring the frictional shear stress along the filament/coating/matrix interface. This is the shear stress required to overcome friction and push the filament out of the piece of composite.

Low frictional stresses are desirable since they give a more effective mechanical decoupling between the filaments and the matrix, leading to a tougher composite.

A detailed description of the test used in the present analysis can be found in Scripta Met. & Mat. 24, 1990, pp 469-474 and in J. Mat. Sci. Lett, 8, 1989, pp 1451-1454.

The coated filaments were consolidated into a Ti-6-4 matrix. The specimens were thinned to a wedge and mounted on an aluminium base plate with a groove cut into it. The filaments were arranged to run vertically, perpendicular to the base plate.

The specimen was mounted on a Vickers Hardness tester. The pyramidal diamond was placed on the end of one of the filaments and a load applied until the filaments started to be pushed out of the composite. This procedure was repeated for different filaments with lengths of up to 160 microns. A plot of force required to push out the filament against filament length gave the interfacial frictional shear stress.

The results from this test are given in Table 1. A composite prepared from coated filaments according to the present invention (filament 1) exhibits low shear stress. The use of a tube comprising two distinct regions therefore produces a bilayered coating which has a lower friction carbon layer and is an improvement over the coatings produced from a single region tube.

### Table 1. Measurement of Frictional Shear Stress

| Filament | Tube Dimensions | | Frictional Shear Stress (MPa) |
|---|---|---|---|
| | Length (m) | diameter (mm) | |
| 1 | 1.0 } 0.3 | 32 } 22 | 40-90 |
| 2 (Comparative Example) | 1.5 | 32 | 110-130 |
| 3 (Comparative Example) | 1.3 | 22 | 127 |

## Claims

1. A process for the deposition of a carbon coating on a ceramic filament which comprises passing the heated filament through a deposition chamber containing gases which, on contact with the hot filament, deposit a carbon coating; characterised in that the deposition chamber comprises distinct first and second regions, the first region having a greater diameter than the second region.

4

2. A process according to claim 1 wherein the first region forms the upper section of the deposition chamber and the second region forms the lower section of the deposition chamber.

3. A process according to claim 1 wherein the gases enter the deposition chamber through the second region and exit the deposition chamber through the first region.

4. A process according to claim 1 wherein the first region has a diameter of 25 to 50 mm and the second region has a diameter of 10 to 25 mm.

5. A process according to claim 1 wherein the first region is $\frac{1}{2}$ to 5 metres in length and the second region is $\frac{1}{4}$ to 5 metres in length.

6. A ceramic filament having a carbon coating, the carbon coating when viewed under a scanning electron microscope comprising at least two distinct layers of carbon; a first layer presenting the visual appearance of a laminated microstructure and a second layer presenting a homogeneous visual appearance.

7. A ceramic filament according to claim 6 in which the first layer is the inner layer and the second layer is the outer layer.

5

FIG.1

FIG. 2

European Patent Office

# EUROPEAN SEARCH REPORT

Application Number

## DOCUMENTS CONSIDERED TO BE RELEVANT

EP 91305783.2

| Category | Citation of document with indication, where appropriate, of relevant passages | Relevant to claim | CLASSIFICATION OF THE APPLICATION (Int. Cl.5) |
|---|---|---|---|
| A | EP - A1 - 0 357 492 (AEROSPATIALE SOCIETE NATIONALE INDUSTRIELLE) * Claims 1-8 * -- | 1-7 | C 04 B 41/87 C 01 B 31/04 |
| A | PATENT ABSTRACTS OF JAPAN, unexamined applications, C field, vol. 5, no. 136, August 28, 1981 THE PATENT OFFICE JAPANESE GOVERNMENT page 4 C 69 * Kokai-no. 56-69 210 * + Abstract + ---- | 1-7 | |

TECHNICAL FIELDS SEARCHED (Int. Cl.5)

C 04 B
C 01 B

The present search report has been drawn up for all claims

| Place of search | Date of completion of the search | Examiner |
|---|---|---|
| VIENNA | 20-10-1991 | HAUK |

EPO FORM 1503 03.82 (P0401)